(19) Europäisches Patentamt

European Patent Office

Office européen des brevets

(11) Numéro de publication : **0 130 260 B1**

(12) **FASCICULE DE BREVET EUROPÉEN**

(45) Date de publication du fascicule du brevet :
15.04.87

(21) Numéro de dépôt : 83430020.4

(22) Date de dépôt : 30.06.83

(51) Int. Cl.⁴ : **H 04 L 5/14**, H 03 K 5/02,
H 04 M 11/06

(54) **Module d'interface pour lignes téléphoniques.**

(43) Date de publication de la demande :
09.01.85 Bulletin 85/02

(45) Mention de la délivrance du brevet :
15.04.87 Bulletin 87/16

(84) Etats contractants désignés :
DE FR GB

(56) Documents cités :
US-A- 4 039 751
US-A- 4 070 545
IBM TECHNICAL DISCLOSURE BULLETIN, vol. 21,
no. 11, avril 1979, pages 4559-4560, New York, US, F.
DELAPORTE et al.: "Logic interface module"

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Froment, Jean-Claude**
**Av. Bellevue**
**F-06270 Villeneuve-Loubet (FR)**
Inventeur : **Pantani, Jean-Pierre**
**270, Chemin du Parriaou**
**F-06640 Saint-Jeannet (FR)**
Inventeur : **Verhaeghe, Michel**
**30, Le Suve**
**F-06140 Vence (FR)**

(74) Mandataire : **Klein, Daniel Jacques Henri**
**Compagnie IBM France Département de Propriété**
**Intellectuelle**
**F-06610 La Gaude (FR)**

EP 0 130 260 B1

**0 130 260**

**Description**

Domaine technique

La présente invention concerne le domaine de la transmission de données et plus particulièrement se rapporte à un module entièrement monolithique intégré dans une microplaquette de silicium qui assure l'interfaçage entre un modem et une ou plusieurs lignes téléphoniques.

Etat de la technique antérieure

Les spécifications (ou normes) de l'administration des PTT distinguent, de façon connue, trois modes de fonctionnement pour le modem, et les conditions de transmission et d'impédances, vues du côté de la ligne, qui leur correspondent. Ces conditions peuvent être résumées dans la table suivante :

Table I

| MODE DE FONCTIONNEMENT DU MODEM | NIVEAU D'EMISSION | IMPEDANCE A RESPECTER |
|---|---|---|
| MARCHE | 0 db | 600 Ω ± 20 % |
| INACTIF | −80 db | 600 Ω ± 20 % |
| ARRET | − | 600 Ω ± 20 % |

Ces spécifications fixent également un gabarit amplitude/fréquence et exigent une grande linéarité du signal. On observe en particulier que, quel que soit le mode du modem, la ligne téléphonique doit toujours être adaptée sur 600 Ω.

On connaît dans l'art antérieur de nombreux circuits qui assurent la fonction d'interfaçage entre le modem et les lignes PTT, soit à travers un dispositif de couplage en ce qui concerne les lignes commutées, soit à travers des transformateurs de ligne en ce qui concerne les lignes louées. A ce jour tous les circuits d'interface, connus de la demanderesse associent dans leur principe pour chaque fonction (émission ou réception) : un circuit actif, basé sur un amplificateur opérationnel, un circuit passif, généralement une résistance de 600 Ω, et enfin un circuit de commutation ; ce dernier consistant essentiellement en un relais électromécanique de type Reed ou un relais électronique, commandé par le mode du modem MARCHE, ARRET (mise hors tension) ou INACTIF.

Prenons l'exemple de la fonction émission dans une ligne louée.

Dans un premier mode de réalisation classique l'amplificateur présente une impédance de sortie très faible par rapport à 600 Ω. Le primaire du transformateur de ligne est relié par une résistance de 600 Ω, au point commun du contact du relais commandé par l'état du modem. Dans le mode MARCHE, le point commun est relié à la sortie de l'amplificateur, dans le mode INACTIF ou ARRET, le point commun est relié à la masse.

Dans un deuxième mode de réalisation classique, l'amplificateur de ligne présente une impédance de sortie de 600 Ω. Dans ce cas, le primaire du transformateur de ligne est relié directement au point commun du relais ; ce dernier est relié à la sortie de l'amplificateur quand le modem est dans l'état MARCHE, et à la masse à travers une résistance de 600 Ω quand le modem est dans le mode ARRET ou INACTIF. La commande de ces relais s'effectue à partir d'un circuit logique faisant partie intégrante du modem.

Dans tous les cas les conditions d'adaptation montrées sur la table I sont bien remplies. Les principes de réalisation se retrouvent identiquement pour la partie réception.

Ainsi dans l'art antérieur, la carte qui assure la fonction d'interfaçage entre le modem et les lignes téléphoniques, comporte schématiquement, pour chaque ligne de la partie émission et de la partie réception, un amplificateur de ligne, au moins une résistance discrète d'adaptation de 600 Ω et un relais de commutation.

Un premier inconvénient évident de tels circuits, provient de la présence de ces relais qu'ils soient électronique ou électromécanique, c'est-à-dire, d'éléments discrets, non intégrable monolithiquement. Cela est évident pour les relais électromécaniques, mais en ce qui concerne les relais électroniques, seuls des relais en technologie FET ont été réalisés à ce jour ; ils présentent par ailleurs des inconvénients graves, en particulier une résistance de conduction en mode direct $R_{on}$ importante de l'ordre de 100 Ω, et fortement dispersée. En ce qui concerne les relais électroniques en technologie bipolaire constitués par des éléments tels que : transistors et résistances, intégrés dans la couche épitaxiale d'un substrat de silicium, l'isolement de ces éléments implique en permanence, la présence de tensions qui polarisent en

2

inverse (pour chaque caisson), la jonction formée entre la couche épitaxiale d'une part, les murs d'isolement et le substrat d'autre part. Or dans la présente application, quand le modem est à l'arrêt, il n'y a plus de tension disponible, de telle sorte que ces relais électroniques en technologie bipolaire auraient un fonctionnement aléatoire et par conséquent les conditions d'adaptation ne seraient plus remplies.

Les éléments discrets présentent des inconvénients connus, surtout du point de vue de la consommation d'énergie et de surface, mais également de leur fiabilité médiocre, de leur coût, etc...

Il est important de noter que chaque amplificateur est dédié à une ligne et à une seule, qui lui correspond. Si au cours du fonctionnement du modem, une ligne est mise hors fonction, l'amplificateur qui lui correspond devient inutilisable. A moins de prévoir des relais supplémentaires pour aiguiller les données transitant par cet amplificateur vers une autre ligne. Cette possibilité présente, outre l'inconvénient de nécessiter des relais supplémentaires, de surcharger inutilement le dit amplificateur par la mise en parallèle de deux primaires de transformateur dans le cas des lignes louées. De même l'extension à de nouvelles lignes nécessite non seulement l'adjonction de nouveaux circuits notamment des relais mais également la modification du circuit de base.

La structure actuelle des circuits d'interface connus se caractérise donc par leur manque de souplesse.

## Exposé de l'invention

Devant les différents inconvénients présentés par les circuits de l'art antérieur, le besoin s'est fait sentir de définir un module qui assume la fonction d'interfaçage du modem avec les lignes téléphoniques en présentant les caractéristiques suivantes :

— il doit être entièrement intégrable sous forme monolithique, dans une microplaquette de silicium et son fonctionnement en mode inactif doit être garanti même en l'absence de toute tension d'alimentation,

— il doit être conçu pour présenter une consommation d'énergie minimale et un rapport coût/performance optimum,

— son architecture doit être conçue pour permettre une grande flexibilité afin de s'adapter aux nombreuses configurations de fonctionnement des modems,

— il doit être empilable ou modulable, c'est-à-dire, présenter une architecture évolutive qui permette simplement, par l'adjonction de modules identiques supplémentaires, d'accroître le nombre de lignes sur lesquelles on désire transmettre, sans nécessiter pour autant des modifications au circuit de base.

Le problème à la base de la présente invention est tout d'abord résolu par une architecture, qui permet à la fois cette flexibilité et cette modularité qui sont recherchées, et ce de la manière indiquée en détail dans la revendication 1.

De façon plus précise, l'invention vise également à rendre cette architecture entièrement intégrable sous forme monolithique, par la suppression totale de toutes les fonctions de commutation, précédemment réalisées par des relais électromécaniques ou électroniques, et à assurer que les conditions d'adaptation requises par les spécifications des PTT soit remplies quel que soit l'état (ou le mode) du modem : ACTIF, INACTIF ou ARRET.

Ces objectifs ont été rendus possibles par la conception, d'une part d'une famille de nouveaux amplificateurs de ligne, qui présentent une grande linéarité en mode ACTIF, un bon isolement en modes INACTIF et ARRET, et dans tous les cas, même en mode ARRET, une impédance de sortie élevée afin de ne pas perturber le réseau téléphonique (lequel réseau sera donc connecté en permanence sur une résistance discrète de 600 $\Omega$) et d'autre part, d'une famille de nouveaux récepteurs de ligne, de la manière indiquée dans les sous-revendications.

D'autres objectifs caractéristiques, et avantages de la présente invention, ressortiront mieux de l'exposé qui suit, fait en référence aux figures annexées à ce texte, qui représentent un mode de réalisation préférée de celle-ci. ·

## Brève description des figures

La figure 1  montre une représentation schématique de l'architecture de deux modules identiques, empilables, conformes à la présente invention.

La figure 2  montre le schéma d'un nouvel amplificateur de ligne, construit autour d'un amplificateur opérationnel commandé conforme à la présente invention.

La figure 3  montre un mode de réalisation préféré dudit amplificateur opérationnel commandé.

La figure 4  montre le schéma d'un nouveau récepteur de ligne conforme à la présente invention.

Les figures 5A à 5H  montrent les différentes configurations permises par la combinaison de deux modules conformes à la présente invention.

## Description de l'invention

1. L'architecture du module de base

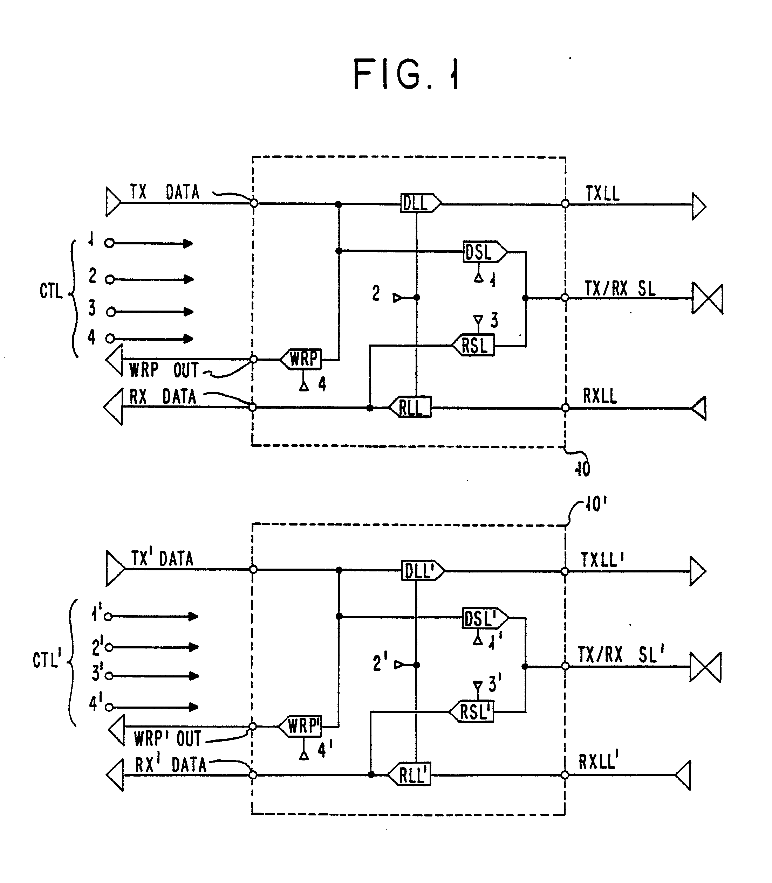

La figure 1 montre une présentation schématique de l'architecture de deux modules identiques 10 et 10' conformes aux enseignements de la présente invention. Le module 10 comporte tout d'abord deux amplificateurs de ligne DLL et DSL respectivement dédiés à une ligne louée TXLL, et à une ligne commutée TX/RX SL. Les entrées de ces amplificateurs sont reliées à une borne commune référencée TX DATA qui reçoit les données à transmettre sur les lignes de l'émetteur du modem. Le module 10 comporte également, de façon symétrique deux récepteurs RLL et RSL qui reçoivent respectivement les données venant d'une ligne louée RXLL et de la ligne commutée TX/RX SL. Les sorties de ces récepteurs sont reliées via une borne commune référencée RX DATA, au récepteur du modem. Bien que l'on ait représenté une ligne commutée de type full-duplex TX/RX SL, 4 fils, il faut comprendre que l'on peut très bien choisir d'avoir deux lignes half-duplex, 2 fils, l'une pour l'émission, l'autre pour la réception. Le module 10 comporte enfin un récepteur supplémentaire WRP, identique aux précédents et disposé entre la borne TX DATA et une borne référencée WRP OUT. Ce récepteur WRP est un élément important du circuit car il joue un rôle déterminant en ce qui concerne la modularité de ce module. Le récepteur WRP est identique à RLL et RSL, mais il n'est jamais branché sur les lignes PTT. On remarquera que le module 10 ne comporte aucun circuit de commutation du genre relais, par contre les circuits amplificateurs et récepteurs sont du type contrôlé, c'est-à-dire que leur état dépend des niveaux logiques qui sont appliqués sur les entrées de commande référencées : 1, 2, 3 et 4. L'implémentation de ces circuits amplificateurs et récepteurs sera détaillée ultérieurement. Les circuits qui ne sont pas actifs sont mis dans un état haute impédance. Sur la figure 1, on a représenté deux modules identiques 10 et 10', parce que, la combinaison ultérieure de ces deux modules, mettra en évidence l'intérêt de cette architecture, en raison des nombreuses possibilités de configuration qu'elle offre.

2. Les amplificateurs de ligne

Dans le but de supprimer les circuits de commutation (relais), la présente invention suggère l'emploi d'un amplificateur de ligne dont la résistance de sortie est très grande par rapport à 600 ohms, et ce, quel que soit le mode du modem, en particulier même à l'ARRET. Pour se comparer aux réalisations classiques de l'art antérieur qui sont mentionnées ci-dessus, on écrira cette fois que le primaire du transformateur de la ligne louée est relié de façon permanente à une résistance de 600 $\Omega$ en parallèle avec lui et à la sortie d'un amplificateur de ligne présentant une impédance de sortie très grande par rapport à 600 $\Omega$, et ce quel que soit le mode de fonctionnement du modem. En outre, cet amplificateur est type contrôlé, c'est-à-dire qu'il est muni d'une entrée de commande CTL (référencée par 1 pour DSL et par 2 pour DLL), qui le mettra dans un état déterminé selon le mode du modem.

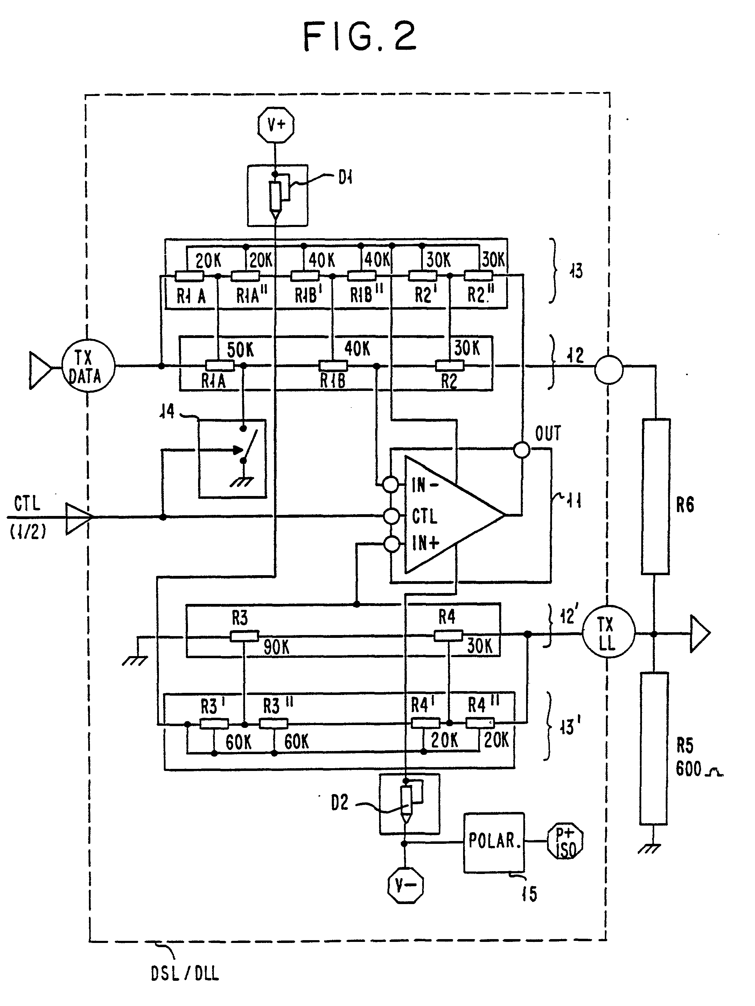

Un circuit qui remplit ces critères est montré sur la figure 2. Cette figure représente un des deux amplificateurs de ligne DLL et DSL montré sur la figure 1.

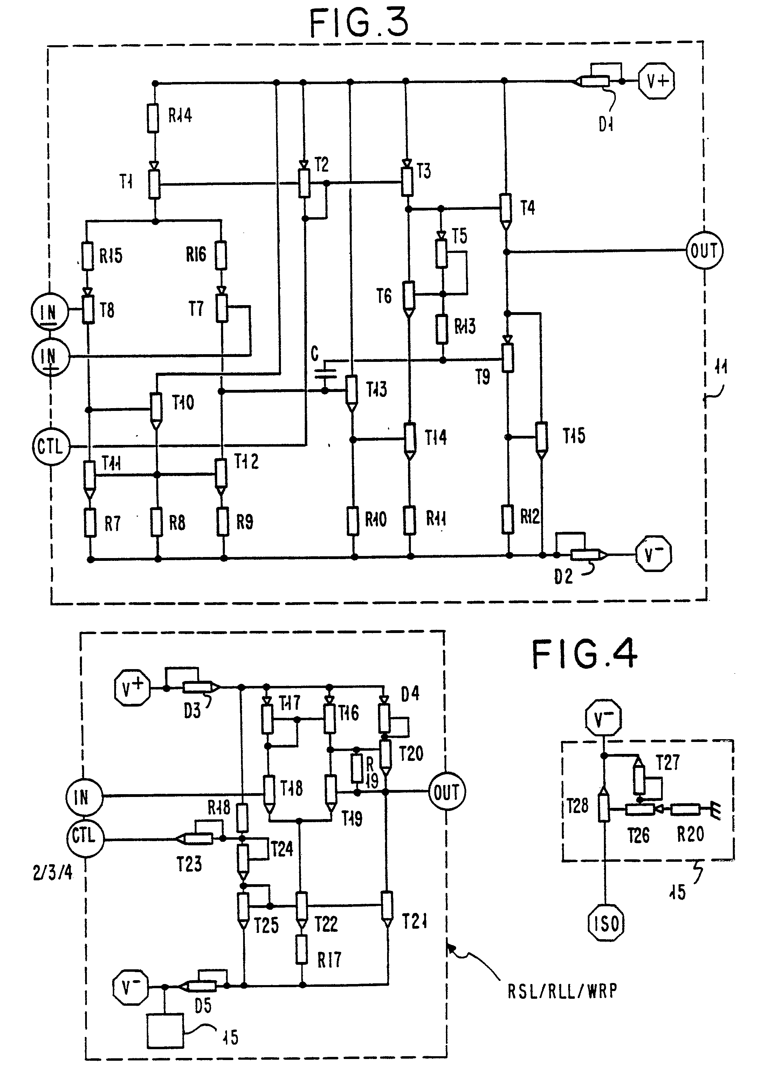

Dans la présente demande, on considérera que ces amplificateurs sont identiques pour la simplicité de l'exposé. Un tel amplificateur de ligne est construit autour d'un amplificateur opérationnel contrôlé 11 de construction originale. Cet amplificateur doit en effet présenter deux caractéristiques non classiques, à savoir il doit être du type à trois états (tristate) et il doit garantir un état de sortie haute impédance (HI) même dans le mode ARRET c'est-à-dire en l'absence des tensions d'alimentation. Le détail de sa réalisation fait l'objet de la figure 3. Pour que l'amplificateur de ligne ait une résistance de sortie quasi-infinie, on associe à l'amplificateur opérationnel 11 deux réseaux de résistance implantées (fig. 2). Le réseau de résistances 12, 12' est une structure qui, associée à l'amplificateur opérationnel 11 assure en mode actif la fonction de générateur de courant. L'apparairage de ces résistances est très bien contrôlé grâce à la technologie de l'implantation ionique, ce qui permet de garantir une valeur très élevée de l'impédance de sortie du circuit de la figure 2 en mode ACTIF. Le réseau de résistance « image » 13, 13' est un réseau qui permet de corriger l'effet de non-linéarité dû au coefficient en tension (VCR) des résistances du réseau 12, 12' dit réseau « principal ».

Le principe de fonctionnement de ces réseaux peut être trouvé dans la référence US-A-4 164 668 (IBM).

Un commutateur analogique 14 est disposé entre la résistance R1A et la masse, et est commandé par le fil CTL de l'amplificateur de ligne. Il garantit un bon isolement entrée/sortie de l'amplificateur en mode INACTIF, en évitant que le signal, ne se propage vers la ligne téléphonique à travers le réseau de résistance 12.

Disposé entre la masse physique du module et la masse virtuelle du réseau de résistance 12, ce commutateur (ouvert quand l'amplificateur est actif) ne perturbe pas le circuit en raison de la faible dynamique du signal entre ses bornes, lorsque l'amplificateur est en mode ACTIF.

Par contre, en mode INACTIF ou ARRET, le commutateur 14 est passant (son impédance devient inférieure à 50 ohms), il permet ainsi d'atténuer par deux ponts de résistances la transmission entréesortie du montage, afin que le taux de réjection (entrée/sortie) soit bien de 80 dB comme indiqué dans la table I.

La diode D1 polarise les lits des résistances des réseaux « principal » et « image », en évitant les fuites en mode ARRET. De plus, elle complète la protection de l'amplificateur opérationnel 11 assurant ainsi une haute impédance par rapport à la masse vu de la ligne téléphonique.

La diode D2, associée à un circuit de polarisation spéciale de l'isolation, permet le blocage des courants de fuites à l'isolation en mode ARRET.

Un dispositif spécial de polarisation 15 est disposé entre l'isolation $P^+$ et la tension $V^-$. Son rôle et sa structure seront détaillés ci-après.

L'amplificateur de ligne comporte enfin deux résistances discrètes : une résistance d'adaptation R5 chargée de fixer l'impédance de sortie de l'ensemble à 0,6 K$\Omega$ et une résistance de détection R6 de l'ordre de 80 $\Omega$ pour ajuster éventuellement la valeur de la transconductance I/V du montage.

Une réalisation préférée de l'amplificateur opérationnel contrôlé 11 est représentée sur la figure 3.

L'amplificateur comprend trois parties :

l'étage d'entrée, l'étage amplificateur de tension et l'étage de sortie, amplificateur de courant.

L'étage d'entrée de type différentiel est constitué par les transistors T1, T7, T8, T10, T11, T12.

Les transistors T10, T11, T12 sont des charges actives qui constituent également un réflecteur de courant. Le transistor T1 monté en source de courant, polarise cet étage.

La sortie de cet étage localisé à la connexion des collecteurs T7 et T12 attaque en courant l'étage amplificateur de tension.

Cet étage amplificateur de tension est composé des transistors T13 et T14 monté en Darlington, associé à la charge active T3. Cette structure, associée à la capacité de compensation C, permet un gain de tension très élevé pour les fréquences basses, mais qui décroit ensuite de 6 dB/octave lorsque la fréquence augmente. Ceci de manière à ce que le gain de cet étage soit inférieur à 1 quand la rotation de phase entrée/sortie tend vers 180° (critère de stabilité).

La sortie de cet étage, attaque les bases de transistors T4 et T9 qui sont montés en mode émetteur-suiveur.

Le transistor PNP T9 est associé à un NPN T15 afin de constituer un « super PNP » qui aura une tâche complémentaire de celle du NPN T4.

Cet étage est polarisé par les transistors T5 et T6 qui assurent un courant minimum de repos dans T4 et dans le super PNP. Ceci garantie la linéarité de l'étage de sortie.

La sortie, localisée à la connexion des émetteurs de T4 et de T9, copie ainsi la tension développée aux bornes de la charge active T3.

Les diodes D1 et D2, associées au dispositif spécial de polarisation de l'isolation 15 décrits ci-dessus, assurent en mode ARRET et INACTIF une isolation de la sortie du montage, par rapport aux alimentations.

Au mode ACTIF, sa résistance de sortie est faible. Dans les modes INACTIF et ARRET, sa sortie est haute impédance et toutes les jonctions entre la sortie d'une part, et les alimentations, $V^+$ OU $V^-$, d'autre part, sont bloquées.

Le fonctionnement du circuit de la figure 2 est donc le suivant, selon le mode de fonctionnement du modem :

mode ACTIF

La structure constituée par l'amplificateur 11, les réseaux de résistances 12, 12' et 13, 13', la résistance R6, constitue un générateur de courant qui alimente la ligne sous une haute impédance. Ce courant est proportionnel à la tension qui apparaît à l'entrée (TX DATA). Dans ce mode de fonctionnement, le commutateur analogique 14 est dans l'état haute impédance. C'est la résistance R5 de 0,6 K ohms qui fixe l'impédance de sortie du montage. La linéarité de l'amplificateur de ligne DSL/DLL est très élevée (distortion < 0,2 %).

Le circuit de la figure 2 assure la transmission des données sur la ligne téléphonique en respectant les spécifications de transmission :

puissance émise sur la ligne : max = OdBm et

impédance vue de la ligne : 0,6 K à 20 %

mode INACTIF

Dans ce cas, le circuit est un générateur de courant nul. Il conserve la même caractéristique d'impédance de sortie que celle qu'il avait en mode actif. C'est la résistance discrète de 0,6 K qui fixe l'impédance de sortie du montage, vue de la ligne.

Le circuit coupe la transmission des données, et assure une bonne isolation du modem et de la ligne téléphonique :

puissance émise sur la ligne : max = — 80 dB et,

impédance vue de la ligne : 0,6 K, ± 20 %

mode ARRET

Dans ce mode, vu de la ligne, le circuit doit présenter là même caractéristique d'impédance de sortie que dans les modes précédents bien que toutes les tensions d'alimentation aient disparu. C'est la conception spéciale de l'étage de sortie de l'amplificateur opérationnel, ainsi que la polarisation spéciale des lits de résistances associées qui préservent l'état haute impédance. Dans ce mode le circuit respecte également les spécifications :

impédance vue de la ligne : 0,6 K, ± 20 %.

Ainsi, dans tous les cas l'impédance vue de la ligne est bien de 0,6 K Ω.

3. Les récepteurs de ligne

Les récepteurs de ligne référencés par RSL, RLL et WRP sur la figure 1 sont choisis identiques pour la simplification de l'exposé. Le circuit d'un récepteur de type contrôlé approprié est montré sur la figure 4. Dans son principe, on-associe à un montage émetteur suiveur classique disposé entre l'entrée IN et la sortie OUT et comprenant les transistors T16 à T22 et la résistance R17 et R19, un dispositif de contrôle, également classique, qui comporte les transistors T23 à T25 et la résistance R18 ; ces derniers permettent en fonction des tensions appliquées sur la borne CTL (qui correspond dans ce cas aux entrées logiques 2, 3 ou 4 de la figure 1), de rendre passant ou de bloquer le montage émetteur suiveur. Des fonctions nouvelles sont réalisées grâce, d'une part aux trois diodes D3, D4 et D5 et d'autre part, au dispositif spécial d'isolation de polarisation 15. Le but de ces trois diodes est d'isoler la sortie de l'émetteur-suiveur du $V^+$ et du $V^-$ quand le modem est en mode ARRET.

De façon plus détaillée, le récepteur comprend trois parties : l'étage d'entrée, l'étage de sortie et le circuit de commande. L'étage d'entrée est constitué par les transistors T18, T19, et il comporte deux charges actives, respectivement les transistors T16 et T17. L'ensemble, polarisé par la source de courant T22, R17, forme un étage amplificateur différentiel, dont la sortie, localisée à la connexion des collecteurs de T16 et T19, est en phase avec l'entrée. L'étage de sortie est composé de T20, monté en émetteur-suiveur et polarisé par T21 ; ce dernier est monté en source de courant et permet le rebouclage entre les étages d'entrée et de sortie, de manière à constituer un amplificateur de gain 1, caractérisé par une impédance d'entrée élevée, et une impédance de sortie faible. Les sources de courant T21, d'une part, et T22, R17 d'autre part, sont polarisées par le circuit de commande, quand celui-ci a son entrée au niveau haut ; le courant est alors fixé par l'ensemble R18, D3, T24, T25 et D5 ; le récepteur se comporte comme un amplificateur suiveur de gain 1.

Quand on attaque l'entrée du circuit de commande par un niveau bas, on coupe le courant dans le transistor T25, et par conséquent dans les sources de courant T22, R17 d'une part, et T21, d'autre part. Les étages d'entrée et de sortie ne sont plus polarisés. Le récepteur présente alors une grande isolation de l'entrée par rapport à la sortie (80 dB minimum de réjection).

Le dispositif 15 poursuit deux buts : le premier est de fournir une polarisation appropriée des régions d'isolation $P^+$ de la microplaquette quand le modem est alimenté en tension (ce qui correspond aux modes ACTIF et INACTIF) ; le second est d'isoler les murs d'isolation du $V^-$, quand le modem n'est plus alimenté (mode ARRET), évitant ainsi un court-circuit entre les régions d'épitaxie (qui contiennent les collecteurs des transistors NPN) et le $V^-$ (qui dans ce cas est la masse).

Le transistor T28 joue le rôle de commutateur. En mode ACTIF et INACTIF, il est saturé, compte tenu de sa polarisation par R20 et T26. En mode ARRET, lorsque la tension $V^-$ atteint la masse, T28 isole les murs d'isolation du $V^-$.

Dans le mode ACTIF, le récepteur possède une grande impédance d'entrée et une faible impédance de sortie. Il est chargé de recopier les signaux venant de la ligne avec une atténuation de 0 dB et une très grande linéarité. En effet, quand l'entrée CTL est portée à un potentiel > 0,6 V, la résistance R18 fournit le courant de polarisation pour la totalité du circuit de la figure 4. Le circuit est alors équivalent à un montage émetteur suiveur classique, le signal d'entrée est disponible en sortie, pratiquement comme s'il y avait un court-circuit entre l'entrée IN et la sortie OUT.

Dans le mode INACTIF, le récepteur bloque les perturbations éventuelles se produisant sur la ligne. Le potentiel de l'entrée CTL est alors inférieur à 0,6 V, la résistance R18 ne fournit plus de courant de polarisation. Tous les transistors du circuit sont bloqués, comme s'il y avait un circuit ouvert entre l'entrée IN et la sortie OUT.

Dans le mode ARRET, le récepteur doit présenter sur son entrée une impédance appropriée (600 Ω). Comme pour l'amplificateur de ligne (DLL, DSL), le primaire du transformateur de ligne est relié de façon permanente à une résistance de 600 Ω en parallèle avec lui et à l'entrée du récepteur qui présente une impédance très grande par rapport à 600 Ω. En l'absence de tension d'alimentation tous les transistors sont également bloqués, mais les trois diodes D3, D4 et D5 ainsi que le dispositif 15 assurent néanmoins une bonne isolation. L'ensemble est équivalent à un contact de relais normalement ouvert.

Dans tous les cas, les caractéristiques d'isolation sont données ci-après :

Table II

| | $V^-$ | $V^+$ | MASSE | ENTREE IN | SORTIE OUT |
|---|---|---|---|---|---|
| ENTREE (IN) | OUI | OUI | OUI. | — | OUI |

4. Application aux différentes configurations du modem

Bien qu'un module tel que 10 puisse être utilisé seul, la complexité des modems requiert un certain nombre de configurations et une grande flexibilité dans leur mise en œuvre. La combinaison de 2 modules conformes à la présente invention autorise de très nombreuses configurations et montre bien l'intérêt de l'architecture choisie. Dans ce cas, on réalisera les connexions préalables suivantes, qui demeureront valables quelle que soit la configuration choisie :

— d'une part, la borne WRPOUT du module 10 est connectée à la borne RX' DATA. Les bornes WRP' OUT et RX' DATA du module 10' sont connectées à la borne RX DATA du module 10.

— d'autre part, les bornes RXLL et TXLL' sont portées au potentiel de la masse.

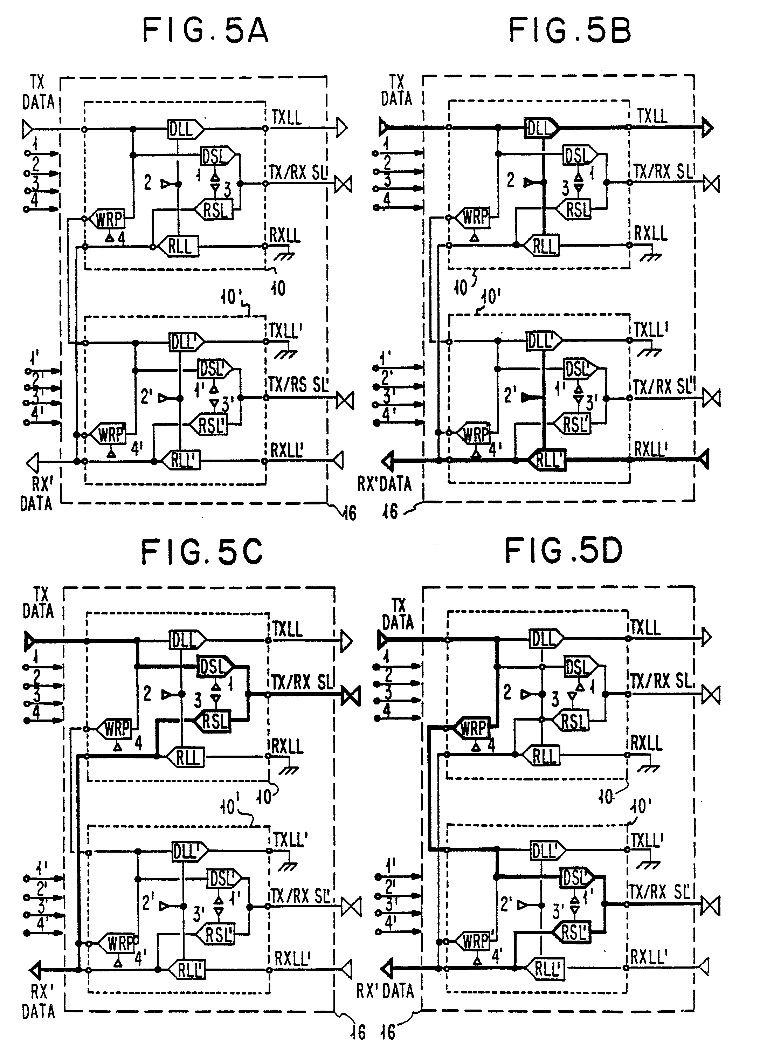

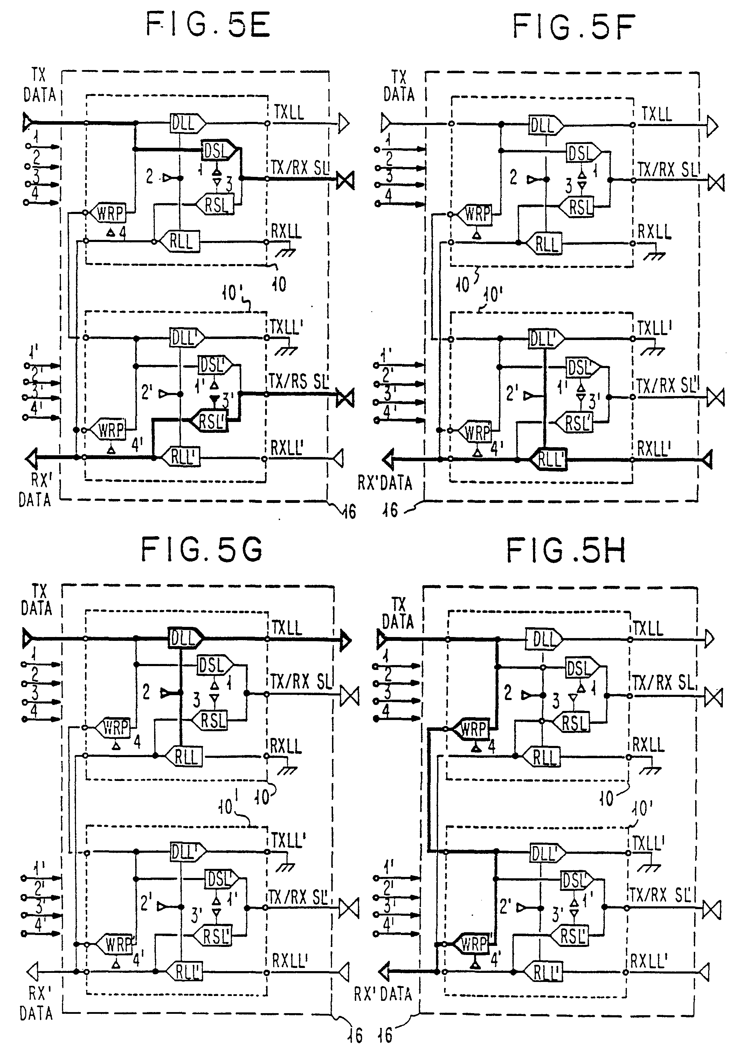

On obtient le module 16 formé par la combinaison des modules 10 et 10' ainsi interconnectés, qui est représenté sur la figure 5A.

Par exemple, pour les six configurations suivantes : émission-réception sur ligne louée 4 fils (LL/DATA 4W), émission-réception ligne commutée 4 fils avec trois configurations différentes (SWL(1)4W), (SWL(2)4W) et (SWL(3)4W), réception sur la ligne louée, modem INACTIF (LL INOP), émission ligne louée en cas de panne d'alimentation (LLPF) et enfin test modem (WRP), la table de vérité est donnée ci-après :

Table III

| ENTREES LOGIQUES | | CONFIGURATIONS DU MODEM | | | | | | |
|---|---|---|---|---|---|---|---|---|
| | | LL/ DATA 4W | SWL (1) 4W | SWL (2) 4W | SWL (3) 4W | LL INOP | LL PF | WRP |
| 1 | | + | 0 | + | 0 | + | x | + |
| 2 | MODULE | 0 | + | + | + | + | 0 | + |
| 3 | | + | 0 | + | + | + | x | + |
| 4 | 10 | G | G | G | G | G | G | G |
| 1' | | + | + | 0 | + | + | x | + |
| 2' | MODULE | 0 | + | + | + | 0 | x | + |
| 3' | | + | + | 0 | 0 | + | x | + |
| 4' | 10' | + | + | + | + | + | x | 0 |
| | | 5B | 5C | 5D | 5E | EF | 5G | 5H |
| | | Voir figure correspondante | | | | | | |

Légende :
x : état logique indifférent
0 : < 0,8 V commande ACTIVE
+ : > 2,4 V commande INACTIVE
G : connexion permanente à la masse.

On a représenté sur les figures 5B à 5H les trajets suivis par les données et l'état logique des différentes entrées de commande.

On remarquera de façon générale, que cette nouvelle construction permet l'émission et la réception d'un signal allant à/ou venant de deux lignes commutées, c'est-à-dire qu'elle assure un multiplexage bidirectionnel (voir figures 5C et 5D).

**Revendications**

1. Module d'interface (10) entre un émetteur/récepteur (par exemple un modem) et une pluralité de lignes de transmissions (par exemple des lignes téléphoniques), intégré dans une microplaquette de silicium caractérisé en ce qu'il comporte :

— des premiers moyens amplificateurs de ligne (DLL) disposés entre une première borne (TX DATA) connectée à l'émetteur du modem et une deuxième borne (TX LL) reliée à une première ligne téléphonique ;

— des seconds moyens amplificateurs de ligne (DSL) disposés entre ladite première borne (TX DATA), la troisième borne (TX RX) SL reliée à une seconde ligne téléphonique ;

ces moyens amplificateurs de ligne sont du type contrôlé par une entrée logique et présentent une impédance de sortie élevée quel que soit l'état des alimentations afin de ne pas perturber les lignes téléphoniques ;

— des premiers moyens récepteurs de ligne (RLL) disposés entre une quatrième borne (RX DATA) reliée à une troisième ligne téléphonique et une cinquième borne reliée au récepteur du modem ;

— des seconds moyens récepteurs de ligne (RSL) disposés entre ladite troisième borne et une quatrième borne (RX DATA) ;

ces moyens récepteurs de ligne sont du type contrôlé par une entrée logique et présentent une impédance d'entrée très élevée pour assurer l'isolement entre leur entrée et leur sortie et ce quel que soit l'état des alimentations.

— des moyens récepteurs de bouclage (WRP) disposés entre ladite première borne (TX DATA) et une cinquième borne (WRPOUT) ;

ces moyens récepteurs de bouclage sont du type contrôlé par une entrée logique.

2. Module d'interface dual (16) caractérisé en ce qu'il comporte deux modules identiques (10, 10') tels que définis à la revendication 1, la borne WRP OUT est connectée à la borne TX' DATA et les bornes WRP' OUT et RX' DATA du second module (10') sont connectées à la borne RX DATA, les bornes RXLL et TXLL' sont reliées à la masse.

3. Module d'interface (10, 16) selon la revendication 1 ou 2 caractérisé en ce que lesdits moyens amplificateurs de ligne comportent un amplificateur opérationnel (11) du type contrôlé par une entrée de commande (CTL) associé à un réseau de résistances (12, 12') dit réseau « principal », des moyens d'isolation (D1, D2) disposés sur le chemin des tensions d'alimentation $V^+$ et $V^-$ pour garantir une impédance de sortie très élevée, quel que soit l'état des tensions d'alimentation et des moyens de polarisation (15) du substrat par rapport à l'isolation $P^+$.

4. Module d'interface (10, 16) selon la revendication 3 caractérisé en ce que lesdites résistances sont des résistances implantées et qu'un réseau « image » (13, 13') est associé au réseau « principal » afin de corriger le VCR des résistances du réseau « principal » et d'améliorer ainsi la linéarité des moyens amplificateurs de ligne.

5. Module d'interface (10, 16) selon la revendication 4 caractérisé en ce que, il comporte en outre, un commutateur analogique, monté en parallèle entre un point intermédiaire du réseau « principal » (12) et la masse, la commande de ce commutateur étant l'entrée de contrôle (CTL) de l'amplificateur opérationnel (11).

6. Module d'interface (10, 16) selon l'une des revendications 1 à 5, caractérisé en ce que lesdits moyens récepteurs de type contrôlé comprennent un montage émetteur-suiveur (T16 à T22, R17) associé à un dispositif de contrôle (T23 à T25, R18) commandé par une entrée logique (CTL).

7. Module d'interface (10, 16) selon la revendication 6 caractérisé en ce qu'il comporte en outre des moyens d'isolation (D3, D4, D5) disposés sur le chemin des tensions d'alimentation $V^+$ et $V^-$, pour assurer une impédance d'entrée très élevée et isoler la sortie du montage émetteur-suiveur (OUT) des tensions d'alimentation $V^+$ et $V^-$ quel que soit l'état de ces alimentations et, des moyens de polarisation et d'isolation (15).

### Claims

1. An interface module (10) disposed between a transmitter/receiver (such as a modem) and a plurality of transmission lines (such as telephone lines) and formed into a silicon chip, characterized in that it comprises :

— first line amplifier means (DLL) provided between a first terminal (TX DATA) connected to the transmitting end of the modem and a second terminal (TX LL) connected to a first telephone line,

— second amplifier means (DSL) provided between said first terminal (TX DATA) and a third terminal (TX RXSL) connected to a second telephone line,

said line amplifier means being controlled by a logic input and exhibiting a high output impedance regardless of whether the power supplies are on or off, to avoid perturbing the telephone lines,

— first line receiver means (RLL) provided between a fourth terminal (RX DATA) connected to a third telephone line and a fifth terminal connected to the receiving end of the modem,

— second line receiver means (RSL) provided between said third terminal and a fourth terminal (RX DATA),

said line receiver means being controlled by a logic input and exhibiting a very high input impedance to isolate their input from their output regardless of whether the power supplies are on or off,

— wrap receiver means (WRP) provided between said first terminal (TX DATA) and a fifth terminal (WRP OUT),

said wrap receiver means being controlled by a logic input.

2. A dual interface module (16) characterized in that it comprises two identical modules (10, 10') as defined in claim 1, with terminal WRP OUT being connected to terminal TX' DATA, terminals WRP' OUT and RX' DATA of the second module (10') being connected to terminal RX DATA, and terminals RXLL and TXLL' being connected to ground.

3. An interface module according to claim 1 or 2, characterized in that said line amplifier means comprises an operational amplifier (11) controlled by a control input (CTL) associated with a resistor network (12, 12') termed « main » network, isolation means (D1, D2) located between supply voltages $V^+$

and V⁻ to ensure a very high output impedance regardless of whether the power supplies are on or off, and biasing means (15) for biasing the substrate with respect to the P⁺ isolation walls.

4. An interface module (10, 16) according to claim 3, characterized in that said resistors are implanted resistors and a « mirror image » network (13, 13') is associated with the « main » network to correct the VCR of the resistors in said « main » network to thereby improve the linearity of said line amplifier means.

5. An interface module (10, 16) according to claim 4, characterized in that it further comprises an analog switch parallel-connected between a tap of said « main » network (12) and ground, said switch being controlled via said control input (CTL) of said operational amplifier (11).

6. An interface module (10, 16) according to any one of claims 1 to 5, characterized in that said controlled-type receiver means comprises an emitter-follower circuit (T16-T22, R17) associated with a control circuit (T23-T25, R18) controlled via a logic input (CTL).

7. An interface module (10, 16) according to claim 6, characterized in that it further comprises isolation means (D3, D4, D5) locate between supply voltages V⁺ and V⁻ to provide a very high input impedance and to isolate the output (OUT) of the emitter-follower circuit from supply voltages V⁺ and V⁻ regardless of whether said supply voltages are on or off, and biasing and isolation means (15).


**Patentansprüche**

1. Schnittstellenmodul (10) zwischen einem Sender/Empfänger (zum Beispiel einem Modem) und mehreren Übertragungsleitungen (zum Beispiel Telefonleitungen), in eine Mikroplakette aus Silizium integriert, dadurch gekennzeichnet, dass sie enthält :
— erste Leitungsverstärkermittel (DLL), zwischen einer ersten Klemme (TX DATA) angeordnet, angeschlossen an den Sender des Modems und eine zweite Klemme (TX LL), angeschlossen an eine erste Telefonleitung ;
— zweite Leitungsverstärkermittel (DSL), angeordnet zwischen der besagten ersten Klemme (TX DATA), der dritten Klemme (TX RX) SL, angeschlossen an eine zweite Telefonleitung.
Diese Leitungsverstärkermittel sind vom Typ, der durch einen logischen Eingang gesteuert wird und weisen eine hohe Ausgangsimpedanz auf, unabhängig vom Zustand der Versorgungsleitungen, um die Telefonleitungen nicht zu stören.
— erste Leitungsempfängermittel (RLL), angeordnet zwischen einer vierten Klemme (RX DATA), verbunden mit einer dritten Telefonleitung und einer fünften Klemme, die mit dem Empfänger des Modems verbunden ist ;
— zweite Leitungsempfängermittel (RSL), angeordnet zwischen der besagten dritten Klemme und einer vierten Klemme (RX DATA) ;
diese Leitungsempfängermittel sind vom Typ, der durch einen logischen Eingang gesteuert wird und weisen eine sehr hohe Eingangsimpedanz auf, um zu gewährleisten :
die Isolierung zwischen ihrem Eingang und ihrem Ausgang, unabhängig vom Zustand der Versorgungen,
— Schleifenempfängermittel (WRP), angeordnet zwischen der besagten ersten Klemme (TX DATA) und einer fünften Klemme (WRPOUT) ;
diese Schleifenempfängermittel sind vom Typ, der durch einen logischen Eingang gesteuert wird.

2. Dualschnittstellenmodul (16), dadurch gekennzeichnet, dass es zwei gleiche Moduln (10, 10') enthält, wie in Anspruch 1 definiert, wobei die Klemme WRP OUT an der Klemme TX' DATA angeschlossen ist und die Klemmen WRP' OUT und RX' DATA des zweiten Moduls (10') an die Klemme RX DATA angeschlossen sind, während die Klemmen RXLL und TXLL' an die Masse gelegt sind.

3. Schnittstellenmodul (10, 16) gemäss Anspruch 1 oder 2, dadurch gekennzeichnet, dass die besagten Leitungsverstärkermittel einen Operationsverstärker (11) vom Typ enthalten, der durch einen Steuereingang (CTL) gesteuert ist, in Verbindung mit einem Widerstandsnetz (12, 12'), dem sogenanten Hauptnetz, Isolierungsmittel (D1, D2), auf dem Weg der Versorgungsspannungen V⁺ und V⁻ angeordnet, um eine sehr hohe Ausgangsimpedanz zu gewährleisten, unabhängig vom Zustand der Versorgungsspannungen und der Polarisierungsmittel (15) des Substrates in Bezug auf die Isolierung P⁺.

4. Schnittstellenmodul (10, 16) gemäss Anspruch 3, dadurch gekennzeichnet, dass die besagten Widerstände eingesetzte Widerstände sind, und dass ein « Bild »-Netz (13, 13') dem besagten Hauptnetz zugeordnet ist, um den VCR der Widerstände des Hauptnetzes zu berichtigen und damit die Linearität der Leitungsverstärkermittel zu verbessern.

5. Schnittstellenmodul (10, 16) gemäss Anspruch 4, dadurch gekennzeichnet, dass es ausserdem einen Analogschalter enthält, der parallel zwischen einem mittleren Punkt des hauptnetzes (12) und der Masse angeordnet ist, während die Steuerung dieses Schalters der Steuereingang (CTL) des Operationsverstärkers (11) ist.

6. Schnittstellenmodul (10, 16) gemäss einem der Ansprüche 1 bis 5, dadurch gekennzeichnet, dass die besagten Empfängermittel vom gesteuerten Typ eine Senderfolgerschaltung enthalten (T16 bis T22, R17), in Verbindung mit einer Kontrollanordnung (T23 bis T25, R18), gesteuert durch einen logischen Eingang (CTL).

7. Schnittstellenmodul (10, 16), gemäss Anspruch 6, dadurch gekennzeichnet, dass es ausserdem Isoliermittel (D3, 4, 5) enthält, angeordnet am Weg der Versorgungsspannungen $V^+$ und $V^-$, um eine sehr hohe Eingangsimpedanz zu gewährleisten und den Ausgang der Senderfolgerschaltung (OUT) von den Versorgungsspannungen ($V^+$ und $V^-$ zu isolieren, unabhängig vom Zustand dieser Versorgungen und der Polarisierungs- und Isolierungsmittel (15).

# FIG. 1

FIG.2

FIG.3

0 130 260

FIG.4

# FIG.5A

# FIG.5B

# FIG.5C

# FIG.5D

# FIG.5E

# FIG.5F

# FIG.5G

# FIG.5H